# EUROPÄISCHE PATENTSCHRIFT

(11) **EP 1 540 374 B1**
(45) Veröffentlichungstag und Bekanntmachung des Hinweises auf die Patenterteilung: **29.08.2012**
(21) Anmeldenummer: 03740050.4
(22) Anmeldetag: 30.05.2003
(51) Int. Cl.: G01S 17/32, G01S 17/36, H03M 1/20

(54) **VERFAHREN ZUM BESTIMMEN EINER ENTFERNUNG UND ENTFERNUNGSMESSGERÄT MIT VERBESSERUNG DER EFFEKTIVEN AUFLÖSUNG EINES A/D-WANDLERS DURCH PHASENMODULATION DES AUSWERTESIGNALS**
METHOD FOR DETERMINATION OF A DISTANCE AND DISTANCE MEASURING DEVICE WITH IMPROVEMENT OF THE EFFECTIVE RESOLUTION OF AN A/D CONVERTER BY PHASE MODULATION OF THE MEASURED SIGNAL
PROCEDE POUR DETERMINER UNE DISTANCE ET APPAREIL TELEMETRIQUE A RESOLUTION EFFECTIVE AMELIOREE DU CONVERTISSEUR ANALOGIQUE-NUMERIQUE PAR MODULATION DE PHASE DU SIGNAL D'EVALUATION

(30) Priorität: 14.09.2002 DE 10242777
(43) Veröffentlichungstag der Anmeldung: 15.06.2005
(73) Patentinhaber: ROBERT BOSCH GMBH, 70442 Stuttgart (DE)
(72) Erfinder: STIERLE, Joerg, 71111 Waldenbuch (DE); WOLF, Peter, 70771 Leinfelden-Echterdingen (DE)
(74) Vertreter: Daub, Thomas
(86) Internationale Anmeldenummer: PCT/DE2003/001770
(87) Internationale Veröffentlichungsnummer: WO 2004/027452

(56) Entgegenhaltungen:
- EP-A- 0 640 846
- DE-A- 10 005 421
- DE-A- 19 811 550
- US-A- 4 403 857
- US-A- 5 737 085
- REIS G: "DARF ES EIN BISSCHEN MEHR SEIN. OHNE ZUSAETZLICHE AKTIVE BAUSTEINE DIE AUFLOESUNG EINES MIKROCONTROLLER-ADC ERHOEHEN" ELEKTRONIK, FRANZIS VERLAG GMBH. MUNCHEN, DE, Bd. 46, Nr. 2, 21. Januar 1997 (1997-01-21), Seiten 36-38,40-42, XP000691728 ISSN: 0013-5658

## Beschreibung

### Stand der Technik

Die Erfindung geht aus von einem Verfahren zum Bestimmen einer Entfernung nach dem Oberbegriff des Anspruchs 1 und einem Entfernungsmessgerät nach dem Oberbegriff des Anspruchs 10.

Aus der DE 198 11 550 C2 ist ein Verfahren zum Bestimmen einer Entfernung und ein Entfernungsmessgerät bekannt, mit dem eine Entfernung mit Hilfe eines optischen Signals gemessen wird, wobei ein eine Phaseninformation tragendes analoges Auswertesignal zur Bestimmung der Entfernung ausgewertet wird.

Des Weiteren ist aus US,737,085 ein Verfahren zum Bestimmen einer Entfernung mittels eines optischen Signals bekannt, bei dem ein Auswertesignal phasenmoduliert wird, das Auswertesignal einen Analog-Digitalwandler phasenmoduliert erreicht, das die Phaseninformation tragende analoge Auswertesignal in dem Analog-Digitalwandler digitalisiert und die Phaseninformation anschließend in einer Recheneinheit ausgewertet wird.

### Vorteile der Erfindung

Die Erfindung geht aus von einem Verfahren zum Bestimmen einer Entfernung mittels eines optischen Signals, bei dem ein eine Phaseninformation tragendes analoges Auswertesignal in einem Analog-Digitalwandler digitalisiert und die Phaseninformation anschließend in einer Recheneinheit ausgewertet wird. Es wird vorgeschlagen, dass das Auswertesignal phasenmoduliert den Analog-Digitalwandler erreicht, wobei ein analoges Messsignal mit einer Messfrequenz erzeugt wird und das Messsignal in das Auswertesignal überführt wird, wobei die Phasenmodulation des Auswertesignals durch eine Modulation des Messsignals erreicht wird.

Durch die Erfindung kann der Quantisierungsfehler des Analog-Digitalwandlers gering gehalten werden. Im Vergleich zu bekannten Verfahren und Entfernungsmessgeräten kann bei gleicher Qualität des Auswertesignals die Phasenauflösung verbessert oder die Messzeit bei gleicher Phasenauflösung verringert werden.

Die Erfindung geht hierbei davon aus, dass der Analog-Digitalwandler, in dem das analoge Auswertesignal digitalisiert wird, das Auswertesignal mit einer vorgegebenen Auflösung digitalisiert. Die Auflösung ist hierbei charakterisiert durch diejenige Spannungserhöhung, im Folgenden Digitalisierungsquant genannt, die den Analog-Digitalwandler jeweils zum Weiterschalten von einem digitalen Ausgabewert zum nächsten veranlasst. Bei einem Abtasten einer Spannungsschwingung des Auswertesignals an mehreren zeitlich versetzten Punkten gibt der Analog-Digitalwandler für jeden Abtastpunkt jeweils einen digitalen Wert an eine Recheneinheit weiter. Die Recheneinheit kann aus diesen Werten die Phasenlage eines diese Werteaufweisenden Auswertesignals berechnen, falls die Form des Auswertesignals - beispielsweise eine Sinuskurve - vorgegeben ist.

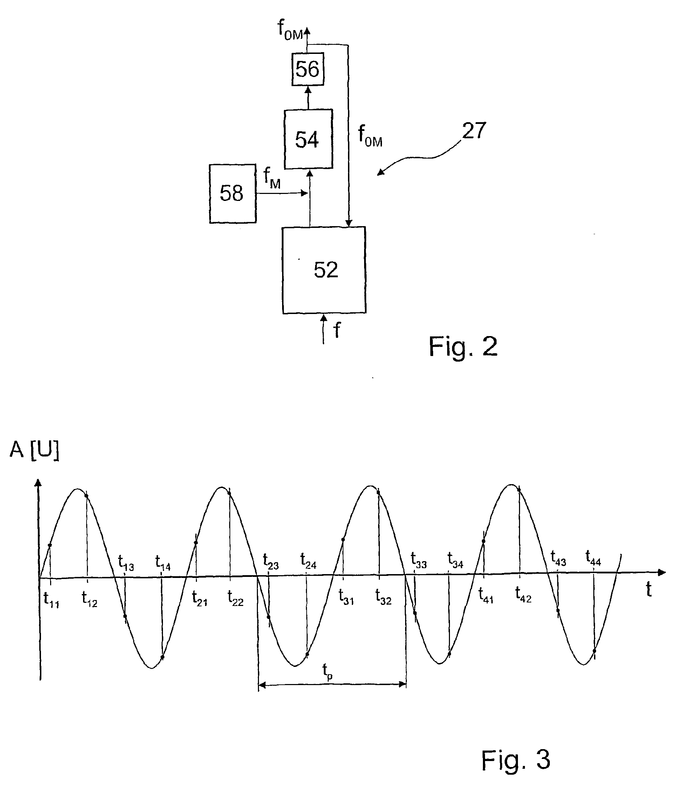

Zur Erhöhung der Auswertegenauigkeit kann es sinnvoll sein, das periodische Auswertesignal periodisch durch den Analog-Digitalwandler abzutasten, und zwar möglichst so, dass die Abtastfrequenz des Analog-Digitalwandlers einem Vielfachen der Periode des Auswertesignals entspricht. Es wird somit jede Periode des Auswertesignals einige Male, beispielsweise vier Mal, also an vier Stellen, abgetastet. Jeder Periode wird dann ein vom Analog-Digitalwandler ausgegebenes Wertemultipel zugeordnet, bei vier Abtaststellen also vier Werte, aus denen die Phasenlage eines diese Werte aufweisenden Auswertesignals bestimmbar ist. Dies ist beispielhaft in Figur 3 erläutert.

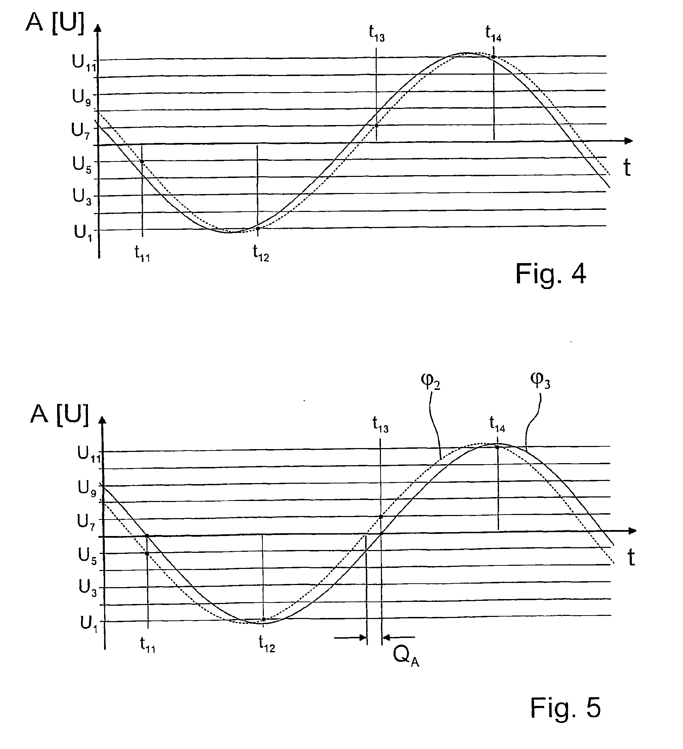

Bei einem Auswertesignal, das kein oder nur wenig Rauschen aufweist, ist es möglich, die tatsächliche Phasenlage des Auswertesignals ein wenig in die eine oder andere Richtung zu verschieben, ohne dass diese Verschiebung den Analog-Digitalwandler zu einer Änderung der ausgegebenen digitalen Werte veranlassen würde. Dies ist in Figur 4 beispielhaft gezeigt. Bei einer Verschiebung der Phase des Auswertesignals in eine Richtung reagiert der Analog-Digitalwandler nach einer gewissen Verschiebung mit einer Änderung eines der Ausgabewerte. Wird die Phase weiter in die Richtung verschoben, reagiert der Analog-Digitalwandler erst nach einer gewissen weiteren Verschiebung wieder mit einer Änderung eines der Ausgabewerte usw. Eine maximale Verschiebung der Phase des Auswertesignals, die zu keiner Veränderung der vom Analog-Digitalwandler ausgegebenen Werte führt, wird im Folgenden als Phasenauflösungsquant bezeichnet. Seine Größe bestimmt die Auflösung der Messung der Phase des Auswertesignals.

Mit einer Phasenmodulation des Auswertesignals, also einer Hin- und Herbewegung der Phase des Auswertesignals, kann erreicht werden, dass der Analog-Digitalwandler beim Abtasten des Auswertesignals über eine Vielzahl von Perioden nicht immer nur gleiche Wertemultipel für jede Periode ausgibt. Durch die Mittelwertbildung der jeweils korrespondierenden Ausgabewerte über alle Wertemultipel kann somit erreicht werden, dass die Phasenlage genauer ermittelbar ist, als dies die Quantisierung des Analog-Digitalwandlers bei Auswertung nur eines Wertemultipels erlaubt.

Ein ähnlicher Effekt wie der durch die Phasenmodulation kann durch Rauschen auf dem Ausgabesignal erreicht werden. Ist das Rauschen stark genug, dass es bei einem Abtasten des Auswertesignals über mehrere Perioden zu unterschiedlichen Wertemultipeln kommt, kann die Phasenlage bei zunehmend langer Abtastung durch Mittelung zunehmend genau ermittelt werden. Die Phasenmodulation hat gegenüber dem Rauschen den Vorteil, dass die Phasenverschiebung im Gegensatz zu einem Rauschen gezielt gesteuert werden kann. Die Phasenmodulation kann hierbei so gesteuert werden, dass eine Mittelung über schon relativ wenige Perioden des Auswertesignals zu einem ausreichend genauen Ergebnis der Phasenermittlung führt. Es kann auf diese Weise mit nur einer kurzen Messzeit eine ausreichend genaue Ermittlung der Phasenlage und somit insbesondere der Entfernung erfolgen.

Die Modulation kann eine Frequenz- oder eine Phasenmodulation sein. Hierdurch wird ermöglicht, dass eine Messung der Entfernung mit Hilfe des Messsignals durchgeführt werden kann, wobei die Messfrequenz unterschiedlich zur Auswertefrequenz des Auswertesignals sein kann. Es kann beispielsweise vorteilhaft sein, mit einer sehr hohen Frequenz Messungen auszuführen und damit zu einer hohen Entfernungsauflösung zu kommen. Gleichzeitig kann an einem wesentlich niederfrequenteren Auswertesignal die Ermittlung der Phaseninformation erfolgen, was die Kosten für die Auswerteschaltungen niedrig hält.

Vorteilhafterweise führt die Phase des Auswertesignals regelmäßige und symmetrische Schwankungen um eine mittlere Phasenlage herum aus. Bei einer solchen Phasenmodulation kann die Mittelung der Werte von nur wenigen Wertemultipeln schon sehr schnell zu einem genauen Mittelwert führen, der eine ausreichend genaue Bestimmung der Phasenlage des Auswertesignals erlaubt. Unter "regelmäßig" wird hierbei eine zeitliche Regelmäßigkeit verstanden. Die Schwankung, also Hin- und Herbewegung auf einer Zeitachse, verläuft somit regelmäßig periodisch von einem Extrem in das andere Extrem und zurück. Die Phase des Auswertesignals bewegt sich außerdem symmetrisch. Es sind somit die Extrema beidseitig auf einer Zeit- bzw. Phasenwinkelachse gleich weit entfernt von der mittleren Phasenlage. Die Schwankung selbst kann hierbei kontinuierlich erfolgen, beispielsweise in Form einer Sinusmodulation, oder diskontinuierlich springen in Form einer Rechteckmodulation oder kann andere, dem Fachmann als geeignet erscheinende Formen annehmen.

Besonders einfach kann die Phasenmodulation durch eine Frequenzmodulation erreicht werden. Hierbei kann die Frequenz des Messsignals oder direkt die Frequenz des Auswertesignals moduliert werden. Die Frequenz sollte so moduliert werden, dass das Auswertesignal phasenmoduliert den Analog-Digitalwandler erreicht.

Vorteilhafterweise führt die Frequenz des Messsignals regelmäßige und symmetrische Schwankungen um eine mittlere Frequenz herum aus. Wie oben zu den Schwankungen der Phase beschrieben, lässt sich auch durch eine regelmäßige und symmetrische Schwankung der Frequenz besonders schnell ein gemitteltes Ergebnis der Wertemultipel des Analog-Digitalwandlers erreichen, das die Phase des Auswertesignals mit hoher Genauigkeit wiedergibt.

Eine einfache Steuerung der Frequenzmodulation kann erreicht werden, indem die Frequenzmodulation durch das Eingeben eines Modulationssignals in eine VCO-Schaltung erfolgt. Die VCO-Schaltung umfasst einen Voltage Controlled Oszillator. Dieser gibt in Abhängigkeit von der in ihn eingegebenen Eingangsspannung eine festgelegte Frequenz aus. Wird als Eingangssignal eine konstante Spannung in die VCO-Schaltung eingegeben, so gibt die VCO-Schaltung eine im Wesentlichen konstante Frequenz aus. Durch die Modulation des Eingangssignals oder das Eingeben eines zusätzlichen Modulationssignals in die VCO-Schaltung kann auf einfache Weise eine gewünschte Frequenzmodulation erreicht werden.

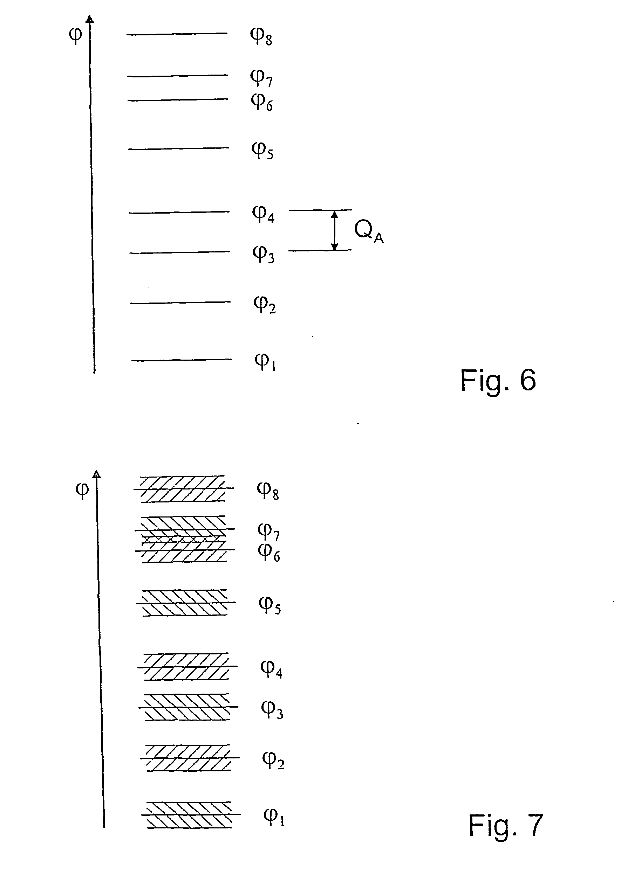

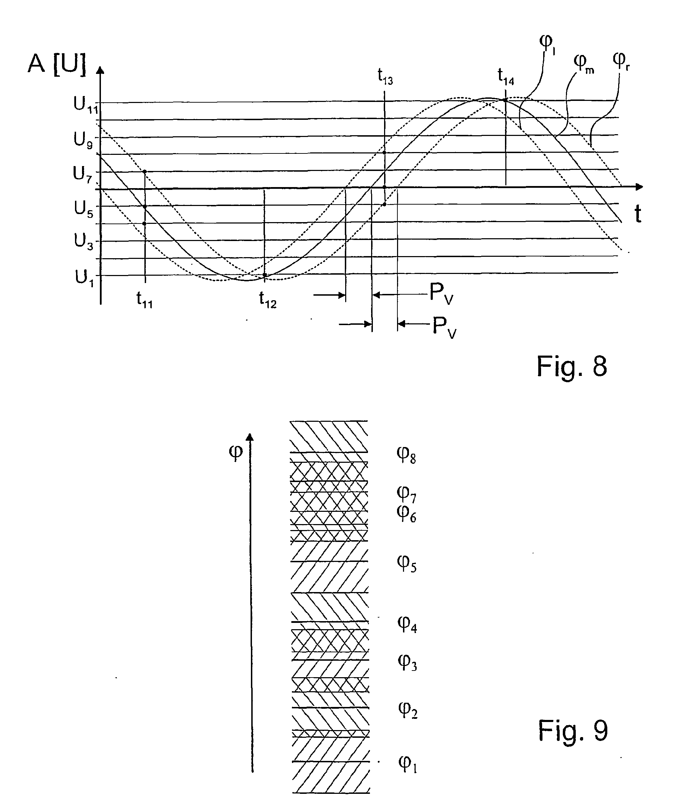

Eine zuverlässige genaue Bestimmung der Phasenlage des Auswertesignals kann erreicht werden, indem die Phasenmodulation des Auswertesignals auf den Analog-Digitalwandler abgestimmt ist und die Phase des Auswertesignals durch die Phasenmodulation um mindestens ein Viertel, insbesondere um mindestens die Hälfte, des größten Phasenauflösungsquants beidseitig um eine mittlere Phasenlage herum verschoben wird. Die Größe der Phasenauflösungsquanten ist abhängig von der Größe des Digitalisierungsquants des Analog-Digitalwandlers, also seiner Auflösung, und von der Form und der Amplitude des Auswertesignals. Die Phasenauflösungsquanten einer Periode, die in den Figuren 5 und 6 näher beschrieben sind, müssen nicht gleich groß sein. Es kann durchaus sein, dass bei einer kontinuierlichen Verschiebung der Phasenlage des Auswertesignals die Änderung der Werte eines Wertemultipels des Analog-Digitalwandlers nicht regelmäßig erfolgt, so dass es einen größten und einen kleinsten Phasenauflösungsquanten in jeder Periode gibt. Wie groß die Phasenmodulation sein muss, um eine zuverlässige genaue Bestimmung der Phasenlage erreichen zu können, hängt unter anderem auch vom Rauschen ab, mit dem das Auswertesignal behaftet ist. Bei großem Rauschen ist keine Phasenmodulation nötig, um zuverlässig zu einem genauen Ergebnis zu kommen. Es ist jedoch eine lange Messzeit nötig. Bei keinem Rauschen wird eine zuverlässige genaue Bestimmung der Phasenlage erreichbar, wenn die Phase des Auswertesignals um mindestens die Hälfte des größten Phasenauflösungsquants des Analog-Digitalwandlers beidseitig um eine mittlere Phasenlage herum verschoben wird. Dann überlappen sich - wie in Figur 9 näher erläutert ist - die Bereiche, in denen die Phasenlage genau bestimmbar ist. Es ist bei mäßigem Rauschen bereits mit einer Phasenmodulation um ein Viertel der Größe des größten Phasenauflösungsquants eine zuverlässige Bestimmung der Phasenlage bei gleichzeitig kurzer Messzeit möglich.

Eine besonders leichte Ermittlung der Mittelwerte der Werte der Wertemultipel lässt sich erreichen, indem das Auswertesignal eine Auswertefrequenz aufweist, die ein ganzzahliges Vielfaches der Modulationsfrequenz ist. Eine Modulationsperiode, also eine Hin- und Herbewegung der Phase auf der Zeit- bzw. Phasenwinkelachse, umfasst dann genau einige Perioden des Auswertesignals. Der Mittelwert kann dann über die Wertemultipel der Perioden gebildet werden, ohne dass Bruchteile von Perioden des Auswertesignals und damit Bruchteile von Wertemultipeln entstehen.

Zweckmäßigerweise weist das Auswertesignal eine Auswertefrequenz auf, wobei die Modulationsfrequenz um mindestens den Faktor 3 kleiner als die Auswertefrequenz ist. Bei einem solchen Abstand der Frequenzen sind die Frequenzen bei der Auswertung leicht durch Filtern trennbar.

Bezüglich der Vorrichtung geht die Erfindung aus von einem Entfernungsmessgerät, insbesondere einem Laserentfernungsmessgerät, mit einer Vorrichtung zur Erzeugung eines eine Phaseninformation tragenden analogen Auswertesignals, einem Analog-Digitalwandler zur Digitalisierung des Auswertesignals und einer Recheneinheit zur Auswertung der Phaseninformation. Es wird vorgeschlagen, dass das Entfernungsmessgerät eine Modulationseinheit zur Phasenmodulation des Auswertesignals aufweist. Wie oben beschrieben, ist so eine genaue Ermittlung der Phasenlage des Auswertesignals bei gleichzeitig geringer Messzeit erreichbar.

Vorteilhafterweise umfasst das Entfernungsmessgerät einen Oszillator zur Erzeugung eines Grundsignals einer Grundfrequenz, wobei die Modulationseinheit zur Modulierung der Grundfrequenz mit Hilfe einer VCO-Schaltung vorgesehen ist. Hiermit kann auf einfache und preiswerte Weise eine Modulierung einer hohen Frequenz erreicht werden.

Eine einfache Steuerung der Frequenzmodulation kann erreicht werden, indem die Modulationseinheit zur Spannungsmodulation des Eingangssignals der VCO-Schaltung vorgesehen ist.

### Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine schematische Darstellung der Schaltung eines Entfernungsmessgeräts,
- Fig. 2: eine Prinzipdarstellung einer Frequenzmodulationsvorrichtung,
- Fig. 3: ein Auswertesignal mit Abtaststellen eines Analog-Digitalwandlers,
- Fig. 4: ein Auswertesignal mit einer Phasenverschiebung,
- Fig. 5: ein Auswertesignal mit einer anderen Phasenverschiebung,
- Fig. 6: Phasenlagenniveaus eines Messvorgangs an einem Auswertesignal,
- Fig. 7: durch Rauschen aufgeweitete Phasenniveaus,
- Fig. 8: ein phasenmoduliertes Auswertesignal mit Modulationsgrenzen,
- Fig. 9: Phasenlagenniveaus eines Messvorgangs mit Phasenmodulation.

### Beschreibung der Ausführungsbeispiele

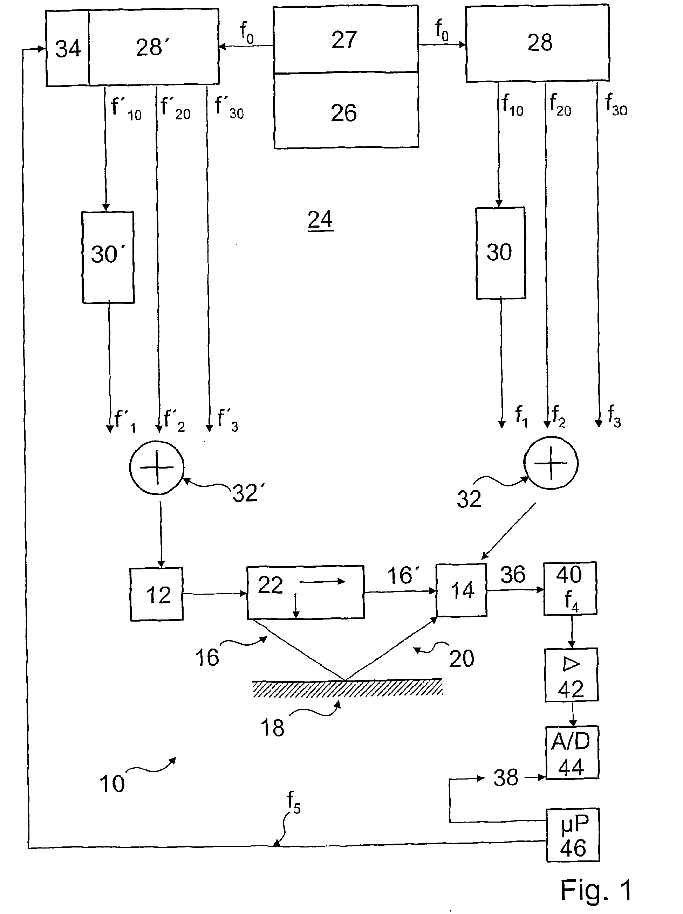

Figur 1 zeigt eine Prinzipdarstellung eines mit 10 bezeichneten Entfernungsmessgeräts. Dieses umfasst einen Lichtsender 12, beispielsweise eine Laserdiode, sowie einen Lichtempfänger 14, der als bekannte Avalanche-Fotodiode ausgebildet ist und das Mischen mehrerer Frequenzen gestattet. Mittels des Lichtsenders 12 wird ein kollimierter, sichtbarer Dauerstrichlaserstrahl als Sendesignal 16 erzeugt, das auf einem Objekt 18, im Folgenden auch Target genannt, sichtbar ist. Vom Objekt 18 wird das Sendesignal 16 nach den Gesetzen der Optik reflektiert und als Empfangssignal 20 von dem Lichtempfänger 14 empfangen. Dem Lichtempfänger 14 wird unmittelbar im Anschluss an die Targetmessung über einen optischen Umschalter 22, beispielsweise eine bewegliche Klappe, das Sendesignal 16 als Referenzsignal 16' zugeführt.

Zur Ansteuerung des Entfernungsmessgeräts 10 ist eine Schaltungsanordnung 24 vorgesehen. Diese umfasst einen Oszillator 26, der als Quarzoszillator mit einer Modulationsvorrichtung 27 ausgeführt ist. Der Oszillator 26 stellt eine Grundfrequenz f₀ bereit, von der alle nachfolgend noch näher erläuterten Frequenzen für den Betrieb des Entfernungsmessgeräts 10 abgeleitet werden. Die Modulationsvorrichtung 27 moduliert die Grundfrequenz f₀ in der Weise, dass die von der Modulationsvorrichtung 27 ausgehende Messfrequenz symmetrisch und regelmäßig um die Grundfrequenz f₀ schwankt.

Um den Eindeutigkeitsbereich der Entfernungsmessung mit dem Entfernungsmessgerät 10 zu erhöhen, wird das Gerät mit insgesamt drei Modulationsfrequenzen für das Sendesignal 16 betrieben. Das Sendesignal 16 selbst ist in bekannter Weise amplitudenmoduliert. Folglich ist auch das Empfangssignal in gleicher Weise amplitudenmoduliert. Dadurch, dass der optische Umschalter 22 zu einem bekannten Zeitpunkt umgeschaltet wird, kann aufgrund der zeitlichen Abfolge eindeutig erkannt werden, ob das momentane optische Empfangssignal direkt vom optischen Umschalter 22 oder vom Objekt 18 herrührt.

Dem Oszillator 26 ist ein erster umschaltbarer Frequenzteiler 28 zugeordnet, der zur Erzeugung von Mischsignalen vorgesehen ist. Der Frequenzteiler 28 teilt die vom Oszillator 26 bereitgestellte Frequenz f₀ wahlweise auf eine Frequenz f₁₀, eine Frequenz f₂₀ sowie eine Frequenz f₃₀ herunter. Dem Frequenzteiler 28 ist eine Schaltungsvorrichtung 30 nachgeschaltet, die aus dem Messsignal mit der Frequenz f₁₀ ein Messsignal mit einer gegenüber der Grundfrequenz f₀ erhöhten Messfrequenz f₁ erzeugt. Die Schaltungsvorrichtung 30 umfasst eine in Figur 1 nicht näher gezeigte PLL- und eine VCO-Schaltung. Das Signal mit der Messfrequenz f₁ sowie die beiden anderen von dem Frequenzteiler 28 ausgehenden Signale mit den Messfrequenzen f₂ und f₃ werden über ein Summierglied 32 als Mischsignal auf den Lichtempfänger 14 gegeben. Hierbei entspricht die Messfrequenz f₂ der vom Frequenzteiler 28 ausgegebenen Frequenz f₂₀ und die Messfrequenz f₃ entspricht der Frequenz f₃₀.
Dem Oszillator 26 ist ein zweiter Signalstrang zugeordnet, der zur Erzeugung des Sendesignals 16 vorgesehen ist. Dieser zweite Signalstrang entspricht im Wesentlichen dem oben beschriebenen Signalstrang, der zur Erzeugung der Mischsignale vorgesehen ist, die direkt auf den Empfänger gegeben werden. Gleiche Bauteile sind mit gleichen und gestrichenen Bezugszeichen versehen. Der Frequenzteiler 28' umfasst ein digitales Phasenschiebeelement 34. An die Ausgänge des Frequenzteilers 28' sind Signale mit den Frequenzen f'₁₀, f'₂₀ und f'₃₀ legbar. Diese Frequenzen werden durch das Phasenschiebeelement 34 mit einer Frequenz f₅ in ihrer Phase weitergeschaltet. Dadurch entsteht im Frequenzspektrum ein Gemisch aus mehreren Frequenzlinien.

Der Lichtempfänger 14 wird in zeitlich hintereinander liegender Abfolge jeweils gleichzeitig mit den Mischsignalen mit den ungestrichenen Frequenzen und den Targetsignalen 20 bzw. den Referenzsignalen 16' mit den gestrichenen Frequenzen beaufschlagt. Hierdurch erfolgt in bekannter Weise eine Transformation durch Mischen auf ein Auswertesignal 36. Dieses Auswertesignal 36 enthält die benötigte Grundinformation, nämlich den Phasenwinkel des Targetsignals 20 in Bezug auf einen A/D-Wandlertakt 38 einerseits und zeitlich nachfolgend den Phasenwinkel des Referenzsignals 16' in Bezug auf den A/D-Wandlertakt 38 andererseits. Durch Differenzbildung beider Phasenwinkel pro Messfrequenz fällt die Bezugsgröße heraus, da sie in allen nacheinander folgenden Messungen unverändert ist. Als Ergebnis ergibt sich ein Phasenwinkel pro Messfrequenzpaar f'₁-f₁, f'₂-f₂ und f'₃-f₃, insgesamt also drei Phasenwinkel. Die kleinste Frequenz der Messfrequenzen f'₁, f'₂ und f'₃ bestimmt den Eindeutigkeitsbereich der gesamten Entfernungsmessung. Die größte Frequenz der Messfrequenzen f'₁, f'₂ und f'₃ bestimmt die maximal mögliche Messgenauigkeit bei gegebener Messzeit.

Die Frequenz f₃ ist relativ klein gewählt, um einen langsamen A/D-Wandler einsetzen zu können. Das Auswertesignal 36 wird über einen Anti-Alising-Filter 40, der einen Bandpassfilter für das Auswertesignal 36 der Frequenz f₄ bildet, geführt und von diesem in einen Verstärker 42 auf einen Analog-Digitalwandler 44 geleitet. Das gewandelte Auswertesignal 36 wird einem Mikroprozessor 46 zugeführt, der entsprechende Rechenwerke, Speicherwerke, Zählwerke usw. zur Bestimmung der Entfernung des Objekts 18 vom Entfernungsmessgerät 10 aufweist. Über den Mikroprozessor 46 wird gleichzeitig der A/D-Wandlertakt 38 zur Ansteuerung des Analog-Digitalwandlers 44 bereitgestellt. Ferner wird ein zu dem A/D-Wandlertakt 38 in zumindest teilweise festem Verhältnis stehendes Signal (Triggersignal) des Mikroprozessors 46 mit der Frequenz f₅ zur Verschiebung der Frequenzen f₁₀, f₂₀ und f₃₀ zu den Frequenzen f'₁₀, f'₂₀ und f'₃₀ ausgenutzt.

Im Ausführungsbeispiel wird angenommen, dass der Oszillator 26 ein Grundsignal mit der Grundfrequenz f₀ = 60 MHz erzeugt. Der Frequenzteiler 28 teilt die Grundfrequenz f₀ in die Frequenzen f₁₀ = 30 MHz, f₂₀ = 15 MHz und f₃₀ = 1,875 MHz. Das Signal mit der Frequenz f₁₀ wird in der Schaltungsvorrichtung 30 auf die Messfrequenz f₁ = 900 MHz erhöht. Der zweite dem Oszillator 26 zugeordnete Frequenzteiler 28' teilt die Grundfrequenz f₀ von 60 MHz in analoger Weise wie der Frequenzteiler 28 in Signale mit den Frequenzen f'₁₀, f'₂₀ und f'₃₀ herunter, wobei die Frequenzen f'₁₀, f'₂₀ und f'₃₀ gegenüber den Frequenzen f₁₀, f₂₀ und f₃₀ um die Frequenz f₄ digital verschoben sind. Die Frequenz f₄ beträgt 2,929 kHz, so dass die Messfrequenz f'₁ 899,997 MHz, die Messfrequenz f'₂ 14,997 MHz und die Messfrequenz f'₃ 1,872 MHz beträgt. Sämtliche Frequenzen werden mit Hilfe des Triggersignals der Frequenz f₅ des Mikroprozessors 46 digital erzeugt. Das Triggersignal f₅ weist beispielsweise bei der Frequenz f₁₀ = 15 MHz genau die 4-fache Frequenz von f₄ auf. Bei jedem Takt des Triggersignals mit der Frequenz f₅ = 11,716 kHz wird die Phase des Signals mit der Frequenz f₁₀ um 90° verschoben, so dass eine Verschiebung von 360° mit der Frequenz f₄ = 2,929 kHz geschieht. Das die Phaseninformation tragende Auswertesignal 36, das durch die Mischung der ungestrichenen Frequenzen mit den um f₄ verschobenen Frequenzen des Sendesignals 16' bzw. Targetsignals 20 gebildet wird, weist somit die Frequenz f₄ = 2,929 kHz auf. In weiteren Ausführungsbeispielen sind selbstverständlich auch andere Frequenzen möglich.

Figur 2 zeigt eine schematische Darstellung der Modulationsvorrichtung 27, die eine PLL-Schaltung 52 und eine VCO-Schaltung 54 umfasst. Die VCO-Schaltung 54 ist ein Voltage Controlled Oszillator (Spannungsfrequenzumsetzer) und ist zur Ausgabe eines Signals mit der Frequenz f₀ oder mit einer Frequenz, die in einem Bereich um die Frequenz f₀ herum liegt, ausgelegt. Die PLL-Schaltung 52 ist eine Phase Lock Loop (Phasenbegrenzungskreis). Die Modulationsvorrichtung 27 umfasst einen LC-Filter 56, der eine Induktivität und eine Kapazität aufweist. Der LC-Filter 56 filtert Oberschwingungen heraus und dient zur Verbesserung der Signalqualität. Das Signal mit der Frequenz f₀ wird in die PLL-Schaltung 52 eingegeben. Dort wird die Phasenlage dieses Signals mit der Phasenlage des von der VCO-Schaltung 54 stammenden Signals verglichen, wobei der Vergleich der Phasen der beiden Signale in eine Ausgangsspannung der PLL-Schaltung 52 umgewandelt wird. Diese Spannung dient als Eingangsgröße für die VCO-Schaltung 54, die daraus ein Signal mit ebenfalls der Frequenz f₀ erzeugt.

Die Modulationsvorrichtung 27 umfasst außerdem eine Modulationseinheit 58, die die Spannung des Eingangssignals der VCO-Schaltung 54 mit einer Modulationsfrequenz f_{M} moduliert. Die Modulationsfrequenz f_{M} beträgt 292,9 Hz, was 1/10 der Frequenz f₄, um die die gestrichenen Frequenzen verschoben werden, entspricht. Durch die Modulation des Eingangssignals der VCO-Schaltung 54 wird die von der VCO-Schaltung 54 ausgegebene Frequenz f_{0M} um die Grundfrequenz f₀ herum moduliert. Diese modulierte Grundfrequenz f_{0M} wird in die beiden Frequenzteiler 28 bzw. 28' gegeben, wodurch sämtliche Signale bis zum Lichtempfänger 14 gleichartig frequenzmoduliert sind. Es ist somit auch das Targetsignal 20 frequenzmoduliert, mit der Folge, dass bei gleichbleibender Entfernung des Objekts 18 vom Entfernungsmessgerät 10 die Phase des im Lichtempfänger 14 ankommenden Targetsignals phasenmoduliert ist. Im Lichtempfänger 14 wird zwar die Frequenzmodulation durch die Mischung der Messfrequenzen herausgenommen, da das Auswertesignal 36 mit der Frequenz f₄ behaftet ist und nicht mit den einzelnen Frequenzen f₁, f₂, usw. Die Phasenmodulation bleibt im Auswertesignal 36 jedoch erhalten und erreicht somit den Analog-Digitalwandler 44.

Die Modulationseinheit 58 gibt ein solches regelmäßiges Modulationssignal mit der Modulationsfrequenz f_{M} auf das Eingangssignal der VCO-Schaltung 54, dass das modulierte Ausgangssignal der VCO-Schaltung 54 regelmäßige und symmetrische Schwankungen um eine mittlere Frequenz herum ausführt. Hierdurch bedingt führen auch die Mess- und die Mischfrequenzen regelmäßige und symmetrische Schwankungen um eine mittlere Frequenz herum aus. Die Frequenz des Messsignals mit der Frequenz f'₁ beispielsweise schwankt regelmäßig um einen vorgegebenen Betrag in beide Richtungen; die Frequenz wird somit um den gleichen Betrag größer und kleiner als f'₁.

In Figur 3 ist das Abtasten des Auswertesignals 36 durch den Analog-Digitalwandler 44 gezeigt. Das Auswertesignal 36 ist eine Schwingung der Spannung U mit der Amplitude A und ist im gezeigten Diagramm der Einfachheit halber als Sinussignal gegen die Zeit dargestellt. Das Auswertesignal 36 kann jedoch ebenso gut rechteckig sein oder eine andere Form aufweisen. Das mit der Auswertefrequenz schwingende Auswertesignal 36 weist die Periodenlänge t_{P} auf. Der Analog-Digitalwandler 44 tastet das Auswertesignal 36 jeweils vier Mal pro Periodenlänge t_{P} ab. Die Zeitpunkte, an denen der Analog-Digitalwandler 44 das Auswertesignal 36 abtastet, sind mit t₁₁ bis t₁₄ für die erste Periode, mit t₂₁ bis t₂₄ und t₃₁ bis t₃₄ für die zweite bzw. dritte Periode usw. bezeichnet. Die in einer Periode vom Analog-Digitalwandler 44 gemessenen Werte, beispielsweise die zu den Zeitpunkten t₁₁, t₁₂, t₁₃ und t₁₄ gemessenen Werte, werden als Wertemultipel dieser Periode bezeichnet. Bei einem über die gezeigten Perioden gleichbleibenden Auswertesignal 36 stimmen die vom Analog-Digitalwandler 44 gemessenen und einander entsprechenden Werte der Wertemultipel, beispielsweise t₁₁, t₂₁ und t₃₁, überein. Eine Mittelung der Messwerte über mehrere Perioden führt somit zu keiner Änderung der Messergebnisse.

Aus den Werten eines Wertemultipels ist, bei bekannter Form des Auswertesignals 36, die theoretische Phasenlage des Auswertesignals 36 beim Analog-Digitalwandler 44 errechenbar. Die Berechnung der Phasenlage wird vom Mikroprozessor 46 vorgenommen.

Figur 4 zeigt das Auswertesignal 36 über etwas mehr als eine Periode t_{P} als eine durchgezogene Linie. Auf der Abszisse ist die Zeit t aufgetragen mit den Zeitpunkten t₁ bis t₄, an denen der Analog-Digitalwandler 44 das Auswertesignal 36 abtastet. Auf der Ordinate ist die Amplitude A in Spannung U aufgetragen, wobei die Ordinate in die Spannungswerte U₁ bis U₁₁ des Analog-Digitalwandlers 44 eingeteilt ist, von denen in Figur 4 der Übersichtlichkeit halber nur jeder zweite Wert beschriftet ist. Beim Abtasten des Auswertesignals 36 ermittelt der Analog-Digitalwandler 44 zum Messzeitpunkt t₁₁ den Spannungswert U₅, zum Messzeitpunkt t₁₂ den Spannungswert U₁, zum Messzeitpunkt t₁₃ den Spannungswert U₇ und zum Messzeitpunkt t₁₄ den Spannungswert U₁₁. Verschiebt sich die Phase des Auswertesignals 36 beispielsweise nach rechts, so führt das zunächst nicht zu einer Änderung des Wertemultipels (U₅, U₁, U₇, U₁₁). Erst wenn die Phase die gestrichelt dargestellte Position erreicht, ändert sich der erste und der dritte Wert des Wertemultipels zum Zeitpunkt t₁₁ bzw. t₁₃ jeweils auf den Wert U₆. Die Verschiebung der Phase von der durchgezogenen Position bis vor die gestrichelte Position ist somit vom Analog-Digitalwandler 44 nicht detektierbar.

In Figur 5 ist das Phasen-Auflösungsvermögen des Analog-Digitalwandlers 44 beispielhaft erläutert. Die gestrichelt gezeigte Phasenlage des Auswertesignals 36 entspricht der gestrichelten Phasenlage aus Figur 4. Beim Verschieben der Phase des Auswertesignals 36 von links nach rechts springt der erste und der dritte Wert des Wertemultipels zum Zeitpunkt t₁₁ bzw. t₁₃ jeweils auf den Wert U₆. Bei weiterem Verschieben der Phase ändert sich das Wertemultipel erst wieder, wenn die Phase die durchgezogen dargestellte Lage erreicht. Dann springt der erste und der dritte Wert des Wertemultipels zum Zeitpunkt t₁₁ bzw. t₁₃ von U₆ auf U₇ bzw. von U₆ auf U₅. Zwischen den in Figur 5 dargestellten Positionen der Phasenlage ändert sich das Wertemultipel des Analog-Digitalwandlers 44 nicht. Die gestrichelt dargestellte Phasenlage ist mit ϕ₂ und die durchgezogene Phasenlage ist mit ϕ₃ bezeichnet. Der Abstand zwischen den gezeigten Phasenlagen ϕ₂ und ϕ₃, bei denen sich das Wertemultipel bei Verschieben der Phase ändert, ist als Phasenauflösungsquant Q_{A} bezeichnet. Die Größe des Phasenauflösungsquants Q_{A} gibt das Phasenauflösungsvermögen des Analog-Digitalwandlers 44 an.

Der Analog-Digitalwandler 44 ist nicht in der Lage, die Phasenlage kontinuierlich aufzulösen, sondern kann nur diskrete Phasenlagen anzeigen. Die vom Analog-Digitalwandler 44 anzeigbaren diskreten Phasenlagen, von denen beispielhaft nur acht gezeigt und mit ϕ₁ bis ϕ₈ bezeichnet sind, sind im Diagramm in Figur 6 als horizontale Phasenniveaus dargestellt. Diese Phasenniveaus sind nicht notwendiger Weise äquidistant voneinander beabstandet. Ihr Abstand hängt im Wesentlichen von der Form des Auswertesignals 36 und der Anzahl der Abtaststellen des Analog-Digitalwandlers 44 pro Periode des Auswertesignals 36 ab. Bei einer reinen Schwingung des Auswertesignals 36 ohne jegliches Rauschen sind vom Analog-Digitalwandler 44 nur diese Phasenlagen und keine Zwischenwerte ermittelbar.

Um Zwischenwerte detektierbar zu machen, also um die Phasenauflösung des Analog-Digitalwandlers 44 zu steigern, ist es möglich, ein Amplitudenrauschen auf das Auswertesignal 36 zu geben. Das hierdurch verursachte "Zittern" des Auswertesignals 36 führt dazu, dass bei einem Verschieben der Phasenlage ein Wert des Wertemultipels schon vor Erreichen eines diskreten Phasenniveaus auf einen neuen Wert umspringt. Die diskreten Phasenniveaus werden hierdurch etwas "verschmiert", was in Figur 7 für schwaches Amplitudenrauschen beispielhaft durch schraffierte Phasenlagenbereiche gezeigt ist. Die Grenzen der "Verschmierung" sind in Figur 7 nur der Übersichtlichkeit halber scharf gezeichnet. Streng genommen hat die durch Rauschen verursachte "Verschmierung" keine scharfen Grenzen. Das Rauschen reicht aus, um alle Zwischenphasen zwischen den diskreten Phasenlagen ϕ₆ und ϕ₇ messbar zu machen. Zwischen den übrigen gezeigten diskreten Phasenlagen sind jedoch nicht alle Zwischenphasen detektierbar. Um beispielsweise alle Zwischenphasen zwischen den diskreten Phasenlagen ϕ₃ und ϕ₄ messbar zu machen, würde ein stärkeres Rauschen benötigt werden. Noch stärker müsste das Rauschen sein, um alle Zwischenphasen zwischen den am weitesten beabstandeten diskreten Phasenniveaus ϕ₄ und ϕ₅ detektierbar zu machen. Die Zwischenphasen könnten dann durch lange Messzeiten über viele Perioden des Auswertesignals 36 und Mittelung einander entsprechender Werte der Wertemultipel errechnet werden. Der gleiche Effekt, wie oben durch das Amplitudenrauschen, kann auch mittels Phasenrauschen oder Frequenzrauschen erreicht werden.

Ebenso kann der Effekt des "Verschmierens" der diskreten Phasenniveaus durch eine gezielte Phasenmodulation erreicht werden. Eine Phasenmodulation kann durch ein Verschieben der Phase oder durch eine Frequenzmodulation, beispielsweise wie oben beschrieben, erreicht werden. Die wie oben beschriebene durch Frequenzmodulation bewirkte Phasenmodulation ist in Figur 8 beispielhaft gezeigt. Hierbei wird die Phase des Auswertesignals 36 beidseitig hin- und herbewegt. Im Ausführungsbeispiel wird die Phase beidseitig und gleichmäßig um eine mittlere Phasenlage ϕₘ herum hin- und herbewegt. Die maximale Auslenkung in beide Richtungen ist jeweils mit P_{V} angegeben. Die maximal nach links verschobene Phasenlage ist mit ϕₗ und die maximal nach rechts verschobene Phasenlage ist mit ϕᵣ bezeichnet. Die Phasenmodulation bewirkt eine Veränderung des Wertemultipels des Analog-Digitalwandlers 44 für eine Periode: Während der zum Zeitpunkt t₁₁ aufgenommene Messwert für die mittlere Phasenlage ϕₘ U₅ beträgt, beträgt er für die linke Phasenlage ϕₗ U₄ und für die rechte Phasenlage ϕᵣ U₇. Analog verändert sich auch der dritte Wert des Wertemultipels zum Zeitpunkt t₁₃ einer jeden Phase, wohingegen die Werte zu den Zeitpunkten t₁₂ und t₁₄ durch die Phasenmodulation unverändert bleiben.

Der Mittelwert der drei in Figur 8 gezeigten Phasenlagen entspricht genau der Phasenlage (ϕₘ. Eine Messung der drei Phasenlagen - oder der Phasenlagen zwischen den extremen Phasenlagen ϕₗ und ϕᵣ - und eine anschließende Mittelung führt daher zur mittleren Phasenlage ϕₘ. Es kann somit bei einer Messung der Wertemultipel über mehrere Perioden hinweg, in denen die Phase mindestens ein Mal hin- und hergewandert ist, aus der Mittelwertbildung der Werte einander entsprechender Abtastzeitpunkte, also einer Mittelwertbildung über alle Werte der Messung zu den Zeitpunkten t₁₁, t₂₁, t₃₁, t₄₁, usw., der Wert errechnet werden, der der Phasenlage ϕₘ bei sehr hoher Auflösung des Analog-Digitalwandlers 44 entsprechen würde. Es ist somit die Auflösung des Analog-Digitalwandlers 44 durch die auf das Auswertesignal 36 aufgespielte Phasenmodulation "künstlich" erhöhbar, ohne dass ein besser auflösender und somit teurerer Wandler verwendet werden müsste. Es kann auf diese Weise ein einfacherer Wandler verwendet werden, beispielsweise ein 10-Bit-Wandler anstelle eines 12-Bit-Wandlers 44. Hierdurch können Kosten eingespart werden.

Die durch die Frequenzmodulation hervorgerufene und in Figur 8 gezeigte beidseitige Verschiebung der Phasenlage beträgt der Anschaulichkeit halber mehr als der größte Abstand zwischen zwei diskreten Phasenlagen, wie in Figur 6 und 7 beschrieben. Um alle Phasenlagen zwischen den diskreten Phasenlagen ϕᵢ messen zu können, reicht es aus, dass die Verschiebung mindestens die Hälfte des größten Phasenauflösungsquants beträgt. Der größte Phasenauflösungsquant ist der Abstand zwischen den diskreten Phasenlagen ϕ₄ und ϕ₅, wie in den Figuren 6, 7 und 9 gezeigt ist. In Figur 9 ist das durch Frequenzmodulation hervorgerufene "Verschmieren" der diskreten Phasenlagen ϕᵢ durch ein Verschieben der Phasenlagen um etwas mehr als die Hälfte des größten Phasenauflösungsquants gezeigt.

Durch die gezielte Verschiebung der Phase des Auswertesignals 36 kann gegenüber einer "Verschmierung" der diskreten Phasenniveaus durch Rauschen ein sehr genaues Messergebnis der Phasenlage schon nach relativ kurzer Messdauer erreicht werden. Die Mittelung über wenige, beispielsweise 10 Perioden des gezielt modulierten Auswertesignals 36 führt schon zu einem sehr guten Messergebnis. Um ein gleichwertiges Ergebnis mit Hilfe von Rauschen zu erreichen, müssten die korrespondierenden Werte von Wertemultipeln des Analog-Digitalwandlers 44 über erheblich mehr Perioden gemittelt werden.

Denkbar ist auch, eine Kombination von Rauschen und Modulation zum Erreichen eines guten Messergebnisses zu verwenden. In einem solchen Fall reicht es aus, wenn die durch Modulation und Rauschen erzielte "zusammengesetzte Verschmierung" der diskreten Frequenzniveaus sich überall ausreichend überdeckt. So kann die Phase des Auswertesignals durch die Phasenmodulation um beispielsweise mindestens ein Viertel des größten Phasenauflösungsquants beidseitig um eine mittlere Phasenlage herum verschoben werden, wobei der Effekt der erhöhten Phasenauflösung bereits erreicht wird.

### Bezugszeichen

- 10: Entfernungsmessgerät
- 12: Lichtsender
- 14: Lichtempfänger
- 16: Sendesignal
- 16': Referenzsignal
- 18: Objekt
- 20: Empfangssignal
- 22: Umschalter
- 24: Schaltungsanordnung
- 26: Oszillator
- 27: Modulationsvorrichtung
- 28, 28': Frequenzteiler
- 30, 30': Schaltungsvorrichtung
- 32, 32': Summierglied
- 34: Phasenschiebeelement
- 36: Auswertesignal
- 38: A/D-Wandlertakt
- 40: Anti-Aliasing-Filter
- 42: Verstärker
- 44: Analog-Digitalwandler
- 46: Mikroprozessor
- 52: PLL-Schaltung
- 54: VCO-Schaltung
- 56: LC-Filter
- 58: Modulationseinheit
- f₀: Grundfrequenz
- f_{0M}: Modulierte Grundfrequenz
- f_{M}: Modulationsfrequenz
- f₁, f₁': Frequenz
- f₂, f₂': Frequenz
- f₃, f₃': Frequenz
- f₄: Frequenz
- f₅: Frequenz
- f₁₀, f'₁₀: Frequenz
- f₂₀, f'₂₀: Frequenz
- f₃₀, f'₃₀: Frequenz
- t_{P}: Periodenlänge
- tᵢ: Zeitpunkt
- ϕᵢ: Phasenlage
- Q_{A}: Phasenauflösungsquant
- P_{V}: Maximale Auslenkung

## Patentansprüche

1. Verfahren zum Bestimmen einer Entfernung mittels eines optischen Signals, bei dem ein eine Phaseninformation tragendes analoges Auswertesignal (36) in einem Analog-Digitalwandler (44) digitalisiert und die Phaseninformation anschließend in einer Recheneinheit ausgewertet wird, wobei das Auswertesignal (36) phasenmoduliert den Analog-Digitalwandler (44) erreicht, **dadurch gekennzeichnet, dass** ein analoges Messsignal mit einer Messfrequenz (f'₁, f'₂, f'₃) erzeugt wird und das Messsignal in das Auswertesignal (36) überführt wird, wobei die Phasenmodulation des Auswertesignals (36) durch eine Modulation des Messsignals erreicht wird.

2. Verfahren nach Anspruch 1, **dadurch gekennzeichnet, dass** die Phase des Auswertesignals (36) regelmäßige und symmetrische Schwankungen um eine mittlere Phasenlage (ϕₘ) herum ausführt.

3. Verfahren nach einem der vorhergehenden Ansprüche, **dadurch gekennzeichnet, dass** die Phasenmodulation durch eine Frequenzmodulation erreicht wird.

4. Verfahren nach Anspruch 3, **dadurch gekennzeichnet, dass** die Messfrequenz (f'₁, f'₂, f'₃) des Messsignals regelmä-βige und symmetrische Schwankungen um eine mittlere Frequenz herum ausführt.

5. Verfahren nach Anspruch 3 oder 4, **dadurch gekennzeichnet, dass** die Frequenzmodulation durch das Eingeben eines Modulationssignals in eine VCO-Schaltung (54) erfolgt.

6. Verfahren nach einem der vorhergehenden Ansprüche, **dadurch gekennzeichnet, dass** die Phasenmodulation des Auswertesignals (36) auf den Analog-Digitalwandler (44) abgestimmt ist und die Phase des Auswertesignals (36) durch die Phasenmodulation um mindestens ein Viertel, insbesondere um mindestens die Hälfte, des größten Phasenauflösungsquants (Q_{A}) beidseitig um eine mittlere Phasenlage (ϕₘ) herum verschoben wird.

7. Verfahren nach einem der vorhergehenden Ansprüche, **dadurch gekennzeichnet, dass** das Auswertesignal (36) eine Auswertefrequenz aufweist, die ein ganzzahliges Vielfaches der Modulationsfrequenz ist.

8. Verfahren nach einem der vorhergehenden Ansprüche, **dadurch gekennzeichnet, dass** das Auswertesignal (36) eine Auswertefrequenz aufweist und die Modulationsfrequenz um mindestens den Faktor 3 kleiner als die Auswertefrequenz ist.

9. Entfernungsmessgerät, insbesondere Laserentfernungsmessgerät, mit einer Vorrichtung zur Erzeugung eines eine Phaseninformation tragenden analogen Auswertesignals (36), einem Analog-Digitalwandler (44) zur Digitalisierung des Auswertesignals, einer Recheneinheit zur Auswertung der Phaseninformation und mit einer Modulationseinheit (58) zur Phasenmodulation des Auswertesignals (36), **gekennzeichnet durch** eine die Modulationseinheit (58) aufweisende Modulationsvorrichtung (27), die ein analoges Messsignal mit einer Messfrequenz (f'₁, f'₂, f'₃) erzeugt, wobei die Vorrichtung das Messsignal in das Auswertesignal (36) überführt, wobei die Modulationseinheit (58) die Phasenmodulation des Auswertesignals (36) **durch** eine Modulation des Messsignals erreicht.

10. Entfernungsmessgerät nach Anspruch 9, **gekennzeichnet durch** einen Oszillator (26) zur Erzeugung eines Grundsignals einer Grundfrequenz (f₀), wobei die Modulationseinheit (58) zur Modulierung der Grundfrequenz (f₀) mit Hilfe einer VCO-Schaltung (54) vorgesehen ist.

11. Entfernungsmessgerät nach Anspruch 10, **dadurch gekennzeichnet, dass** die Modulationseinheit (58) zur Spannungsmodulation des Eingangssignals der VCO-Schaltung (54) vorgesehen ist.

## Claims

1. Method for determining a range by using an optical signal, in which an analogue evaluation signal (36) carrying a piece of phase information is digitized in an analogue/digital converter (44) and the phase information is then evaluated in a computation unit, wherein the evaluation signal (36) reaches the analogue/digital converter (44) in phase-modulated form, **characterized in that** an analogue measurement signal having a measurement frequency (f'₁, f'₂, f'₃) is produced and the measurement signal is converted into the evaluation signal (36), wherein the phase modulation of the evaluation signal (36) is achieved by modulating the measurement signal.

2. Method according to Claim 1, **characterized in that** the phase of the evaluation signal (36) executes regular and symmetric fluctuations around a mean phase angle (ϕₘ).

3. Method according to either of the preceding claims, **characterized in that** the phase modulation is achieved by frequency modulation.

4. Method according to Claim 3, **characterized in that** the measurement frequency (f'₁, f'₂, f'₃) of the measurement signal executes regular and symmetric fluctuations around a mean frequency.

5. Method according to Claim 3 or 4, **characterized in that** the frequency modulation is effected by inputting a modulation signal into a VCO circuit (54).

6. Method according to one of the preceding claims, **characterized in that** the phase modulation of the evaluation signal (36) is in tune with the analogue/digital converter (44), and the phase of the evaluation signal (36) is shifted by the phase modulation through at least one quarter, particularly through at least half, of the largest phase resolution quantum (Q_{A}) on both sides around a mean phase angle (ϕₘ) .

7. Method according to one of the preceding claims, **characterized in that** the evaluation signal (36) has an evaluation frequency which is an integer multiple of the modulation frequency.

8. Method according to one of the preceding claims, **characterized in that** the evaluation signal (36) has an evaluation frequency, and the modulation frequency is lower than the evaluation frequency by at least the factor 3.

9. Rangefinder, particular a laser rangefinder, having an apparatus for producing an analogue evaluation signal (36) carrying a piece of phase information, an analogue/digital converter (44) for digitizing the evaluation signal, a computation unit for evaluating the phase information and having a modulation unit (58) for phase modulation of the evaluation signal (36), **characterized by** a modulation apparatus (27) which has the modulation unit (58) and which produces an analogue measurement signal having a measurement frequency (f'₁, f'₂, f'₃), wherein the apparatus converts the measurement signal into the evaluation signal (36), wherein the modulation unit (58) achieves the phase modulation of the evaluation signal (36) by modulating the measurement signal.

10. Rangefinder according to Claim 9, **characterized by** an oscillator (26) for producing a fundamental signal having a fundamental frequency (f₀), wherein the modulation unit (58) is provided for the purpose of modulating the fundamental frequency (f₀) by using a VCO circuit (54).

11. Rangefinder according to Claim 10, **characterized in that** the modulation unit (58) is provided for the purpose of voltage modulation of the input signal for the VCO circuit (54).

## Revendications

1. Procédé de détermination d'une distance au moyen d'un signal optique, selon lequel un signal d'interprétation analogique (36) qui transporte une information de phase est numérisé dans un convertisseur analogique/numérique (44) et l'information de phase est ensuite interprétée dans une unité de calcul, le signal d'interprétation (36) atteignant le convertisseur analogique/numérique (44) en étant modulé en phase, **caractérisé en ce qu'**un signal de mesure analogique ayant une fréquence de mesure (f'₁, f'₂, f'₃) est généré et le signal de mesure est transféré dans le signal d'interprétation (36), la modulation de phase du signal d'interprétation (36) étant obtenue par une modulation du signal de mesure.

2. Procédé selon la revendication 1, **caractérisé en ce que** la phase du signal d'interprétation (36) exécute des fluctuations régulières et symétriques autour d'une position de phase centrale (ϕₘ).

3. Procédé selon l'une des revendications précédentes, **caractérisé en ce que** la modulation de phase est obtenue par une modulation de fréquence.

4. Procédé selon la revendication 3, **caractérisé en ce que** la fréquence de mesure (f'₁, f'₂, f'₃) du signal de mesure exécute des fluctuations régulières et symétriques autour d'une fréquence centrale.

5. Procédé selon la revendication 3 ou 4, **caractérisé en ce que** la modulation de fréquence est effectuée par la saisie d'un signal de modulation dans un circuit VCO (54).

6. Procédé selon l'une des revendications précédentes, **caractérisé en ce que** la modulation de phase du signal d'interprétation (36) est accordée sur le convertisseur analogique/numérique (44) et la phase du signal d'interprétation (36) est décalée par la modulation de phase d'au moins un quart, notamment d'au moins la moitié du plus grand quantum de résolution de phase (Q_{A}) des deux côtés autour d'une position de phase centrale (ϕₘ).

7. Procédé selon l'une des revendications précédentes, **caractérisé en ce que** le signal d'interprétation (36) présente une fréquence d'interprétation qui est un multiple entier de la fréquence de modulation.

8. Procédé selon l'une des revendications précédentes, **caractérisé en ce que** le signal d'interprétation (36) présente une fréquence d'interprétation et la fréquence de modulation est inférieure d'au moins un facteur 3 à la fréquence d'interprétation.

9. Télémètre, notamment télémètre à laser, comprenant un dispositif pour générer un signal d'interprétation analogique (36) qui transporte une information de phase, un convertisseur analogique/numérique (44) pour numériser le signal d'interprétation, une unité de calcul pour interpréter l'information de phase et une unité de modulation (58) pour la modulation de phase du signal d'interprétation (36), **caractérisé par** un dispositif de modulation (27) qui présente l'unité de modulation (58), lequel génère un signal de mesure analogique ayant une fréquence de mesure (f'₁, f'₂, f'₃), le dispositif transférant le signal de mesure dans le signal d'interprétation (36), l'unité de modulation (58) obtenant la modulation de phase du signal d'interprétation (36) par une modulation du signal de mesure.

10. Télémètre selon la revendication 9, **caractérisé par** un oscillateur (26) pour générer un signal de base à une fréquence fondamentale (f₀), l'unité de modulation (58) étant prévue pour moduler la fréquence fondamentale (f₀) à l'aide d'un circuit VCO (54).

11. Télémètre selon la revendication 10, caractérisé en ce l'unité de modulation (58) est prévue pour la modulation en tension du signal d'entrée du circuit VCO (54).
